# EUROPÄISCHE PATENTANMELDUNG

(11) **EP 1 122 740 A1**
(43) Veröffentlichungstag der Anmeldung: **08.08.2001**
(21) Anmeldenummer: 00102472.8
(22) Anmeldetag: 04.02.2000
(51) Int. Cl.: G11C 7/20, G11C 7/24

(54) **Integrierter Halbleiterspeicher und Verfahren zum Rücksetzen von Speicherzellen eines integrierten Halbleiterspeichers**

(71) Anmelder: Infineon Technologies AG, 81669 München (DE)
(72) Erfinder: Gammel, Bernd, 81737 München (DE); Kniffler, Oliver, 81737 München (DE); Schögler, Werner, 8042 Graz (AT)
(74) Vertreter: Epping, Wilhelm, Dipl.-Ing.

(57) **Zusammenfassung**

Ein integrierter Halbleiterspeicher mit Speicherzellen (MC) in einem Speicherzellenfeld (1) weist einen Decoder (2) zur Auswahl einer der Speicherzellen (MC) und eine Steuerungsschaltung (3) auf, die mit dem Speicherzellenfeld (1) und dem Decoder (2) verbunden ist. Die Speicherzellen (MC) sind zu einzelnen Einheiten (4) zusammengefaßt, wobei durch die Steuerungsschaltung (3) und den Decoder (2) ein paralleles Rücksetzen der Speicherzellen (MC) innerhalb der Einheiten (4) mit einem vorgegebenen Datensignal (DA) und ein sequentielles Rücksetzen der einzelnen Einheiten (4) mit dem vorgegebenen Datensignal (DA) durchgeführt wird. Die Detektierbarkeit eines beim Rücksetzen entstehenden Stromprofils ist dadurch eingeschränkt, wodurch die Datensicherheit des Halbleiterspeichers gegenüber Angriffen verbessert ist.

## Beschreibung

Die vorliegende Erfindung betrifft einen integrierten Halbleiterspeicher mit Speicherzellen in einem Speicherzellenfeld und ein Verfahren zum Rücksetzen der Speicherzellen des integrierten Halbleiterspeichers.

Integrierte Halbleiterspeicher werden in unterschiedlichen Anwendungen eingesetzt. Beispielsweise werden Halbleiterspeicher in Form von RAMs in einen Prozessorchip, zum Beispiel einer sogenannten CPU (Central Processing Unit), integriert. In einem solchen integrierten Speicher sind beispielsweise Algorithmen oder Ablaufprogramme gespeichert. Diese dienen beispielsweise zur Steuerung eines Controllers in dem betreffenden Prozessor.

Insbesondere bei der Anwendung in Chipkarten sind beim Betrieb eines Prozessors beziehungsweise des integrierten Halbleiterspeichers hohe Anforderungen bezüglich der Datensicherheit zu berücksichtigen. So ist beispielsweise bei einem unerlaubten Angriff auf den Speicherinhalt des integrierten Halbleiterspeichers sicherzustellen, daß die darin gespeicherten Daten vorher gelöscht beziehungsweise unbrauchbar gemacht werden.

Ein Reset beziehungsweise das Löschen eines Halbleiterspeichers ist insbesondere durch ein charakteristisches Stromprofil gekennzeichnet, das beispielsweise an entsprechenden Anschlüssen des Halbleiterspeichers durch sogenanntes DPA (Differencial Power Analysis) analysiert werden kann. Ein charakteristisches Stromprofil kann beispielsweise eine repetitive Struktur über eine lange Zeit beziehungsweise einen ausgeprägten sogenannten Peak aufweisen. Ein solcher ausgeprägter Peak entsteht üblicherweise durch einen parallelen Reset des Halbleiterspeichers. Durch ein Analysieren eines charakteristischen Stromprofils während eines Resets eines Halbleiterspeichers ist es unter Umständen möglich, Rückschlüsse auf das Betriebsverhalten oder den Ablauf eines Ablaufprogramms eines Controllers zu gewinnen. Weiterhin ist es denkbar, bestimmte Triggerpunkte zu detektieren oder auf einen bestimmten Programmtyp rückzuschließen. Die Datensicherheit der Chipkarte insgesamt ist daher im wesentlichen gefährdet.

Die Aufgabe der vorliegenden Erfindung ist es, einen integrierten Halbleiterspeicher mit Speicherzellen in einem Speicherzellenfeld anzugeben, der derart ausgeführt ist, daß beim Löschen beziehungsweise Rücksetzen der Speicherzellen mit einem vorgegebenen Datensignal die Detektierbarkeit eines Stromprofils verringert ist.

Weiterhin besteht die Aufgabe, ein Verfahren zum Löschen beziehungsweise Rücksetzen eines derartigen Halbleiterspeichers anzugeben, das die Detektierbarkeit eines Stromprofils verringert.

Die Aufgabe betreffend den integrierten Halbleiterspeicher wird gelöst durch einen integrierten Halbleiterspeicher mit Speicherzellen in einem Speicherzellenfeld, mit einem Decoder zur Auswahl einer der Speicherzellen, mit einer Steuerungsschaltung, die mit dem Speicherzellenfeld und dem Decoder verbunden ist; bei dem die Speicherzellen zu einzelnen Einheiten zusammengefaßt sind, und bei dem die Steuerungsschaltung und der Decoder derart ausgeführt sind, daß ein paralleles Rücksetzen der Speicherzellen innerhalb der Einheiten mit einem vorgegebenen Datensignal und ein sequentielles Rücksetzen der einzelnen Einheiten mit dem vorgegebenen Datensignal erfolgt.

Die Aufgabe betreffend das Verfahren wird gelöst durch ein Verfahren zum Rücksetzen von Speicherzellen eines integrierten Halbleiterspeichers mit einem vorgegebenen Datensignal, bei dem die Speicherzellen zu Einheiten zusammengefaßt werden, die Speicherzellen innerhalb der Einheiten parallel mit dem vorgegebenen Datensignal rückgesetzt werden, und die einzelnen Einheiten sequentiell mit dem vorgegebenen Datensignal rückgesetzt werden.

Vorteilhafte Aus- und Weiterbildungen sind Gegenstand abhängiger Ansprüche.

Zum Rücksetzen des Halbleiterspeichers mit einem vorgegebenen Datensignal beziehungsweise zum Löschen des Halbleiterspeichers sind die Speicherzellen zu einzelnen Einheiten beziehungsweise Blöcken zusammengefaßt. Die Steuerungsschaltung und der Decoder sind dabei derart ausgeführt und wirken derart zusammen, daß ein paralleles Rücksetzen der Speicherzellen innerhalb der Einheiten und ein sequentielles Rücksetzen der einzelnen Einheiten erfolgt. Die Detektierbarkeit eines Stromprofils während eines Rücksetzvorgangs ist dadurch verringert, da beispielsweise anstelle des Rücksetzens des gesamten Halbleiterspeichers nur kleinere Blöcke beziehungsweise Einheiten von Speicherzellen als Ganzes parallel rückgesetzt werden. Das Stromprofil wird dadurch größtenteils verschleiert, da man durch partitioniertes Löschen beziehungsweise Rücksetzen ein relativ glattes und gleichmäßiges Stromprofil erhält. Durch eingeschränkte Detektierbarkeit des Stromprofils ist es erschwert, beispielsweise Triggerpunkte oder Rückschlüsse auf einen Programmtyp eines Controllers zu gewinnen und damit Rückschlüsse auf das Betriebsverhalten des Controllers.

Die Erfindung eignet sich für beliebige integrierte Halbleiterspeicher, beispielsweise für dynamische Halbleiterspeicher, auch als DRAM bezeichnet. Beispielsweise weist der Halbleiterspeicher Speicherzellen in einem im wesentlichen matrixförmigen Speicherzellenfeld auf, die entlang von Spaltenleitungen und Zeilenleitungen angeordnet sind. Der Decoder ist dann üblicherweise zur Auswahl einer der Spaltenleitungen und einer der Zeilenleitungen ausgebildet.

Die Erfindung ist insbesondere vorteilhaft bei integrierten Halbleiterspeichern verwendbar, die auf Chipkarten angeordnet sind. Deren Datensicherheit kann durch die Erfindung maßgeblich erhöht werden.

Dabei ist es günstig, daß sich das Rücksetzen beziehungsweise Löschen nicht wesentlich von einem Lese- oder Schreibvorgang des Halbleiterspeichers unterscheidet. Im Idealfall unterscheidet sich der Löschvorgang nicht von einem Lese- oder Schreibvorgang des Halbleiterspeichers. Wird der Halbleiterspeicher dabei beispielsweise in Einheiten von Datenworten ausgelesen beziehungsweise beschrieben, so sind die Speicherzellen während des Löschvorgangs ebenfalls zu Einheiten von Datenworten zusammengefaßt. Ein derartiger Löschvorgang ist jedoch meist nur eingeschränkt durchführbar, da der Zeitbedarf für den Löschvorgang bei einem relativ großen Speicher üblicherweise zu groß ist.

Die Größe der Einheiten der Speicherzellen ist deshalb in vorteilhafter Weise in Hinblick auf die Gesamtgröße des zu löschenden Halbleiterspeichers bemessen. Dabei sollten die gesamte Löschzeit und die Glättung des Stromprofils beim Löschvorgang einer einzelnen Einheit von Speicherzellen in einem sinnvollen Verhältnis stehen. Die Größe der Einheiten der Speicherzellen ist beispielsweise derart gewählt, daß eine Einheit alle Speicherzellen entlang einer der Spaltenleitungen oder entlang einer der Zeilenleitungen umfaßt.

In einer weiteren vorteilhaften Ausführung der Erfindung umfassen die Einheiten von Speicherzellen jeweils nur Speicherzellen, die entlang von Spaltenleitungen beziehungsweise Zeilenleitungen angeordnet sind, die nicht aufeinanderfolgen. Dadurch ist es möglich, daß weite Bereiche des Halbleiterspeichers nach einem ersten Löschschritt unbrauchbar gemacht sind. Die Einheiten von Speicherzellen liegen bei einem Löschvorgang also in einer "verzahnten" Anordnung vor.

Dabei ist es insbesondere vorteilhaft, daß die jeweiligen Einheiten jeweils eine Anzahl Speicherzellen umfassen, so daß die Speicherzellen jeweils einer Einheit im wesentlichen über das gesamte Speicherzellenfeld verteilt sind. Dadurch ist durch einen einzigen Löschschritt bereits weitgehend der gesamte Inhalt des Halbleiterspeichers unbrauchbar gemacht, da quer über das Speicherzellenfeld Teile von Daten gelöscht sind. Diese sind dadurch im allgemeinen nicht mehr rekonstruierbar.

Zur Durchführung des Löschvorgangs werden beispielsweise bei einem Halbleiterspeicher mit Speicherzellen, die in einem im wesentlichen matrixförmigen Speicherzellenfeld entlang von Spaltenleitungen und Zeilenleitungen angeordnet sind, alle Zeilenleitungen selektiert. Die Speicherzellen werden dann durch Auswahl einer oder mehrerer Spaltenleitungen mit dem vorgegebenen Datensignal rückgesetzt. Bei der Auswahl der Spaltenleitungen ist es dabei vorteilhaft, daß nur nicht aufeinanderfolgende Spaltenleitungen ausgewählt werden.

In einer weiteren Ausführungsform werden bei einem gleich aufgebauten Halbleiterspeicher eine oder mehrere Zeilenleitungen selektiert und die Speicherzellen durch Auswahl aller Spaltenleitungen mit dem vorgegebenen Datensignal rückgesetzt. Auch hier ist es vorteilhaft, daß bei der Auswahl der Zeilenleitungen nur nicht aufeinanderfolgende Zeilenleitungen ausgewählt werden. Somit kann, wie beschrieben, durch einen einzigen Löschvorgang bereits ein weiter Bereich des Speichers unbrauchbar gemacht werden.

Die Erfindung wird im folgenden anhand der in der Zeichnung dargestellten Figuren näher erläutert. Es zeigen:
- Figur 1: eine schematische Darstellung eines matrixförmigen Speicherzellenfeldes eines Halbleiterspeichers,
- Figur 2: eine Ausführungsform eines erfindungsgemäßen Halbleiterspeichers.

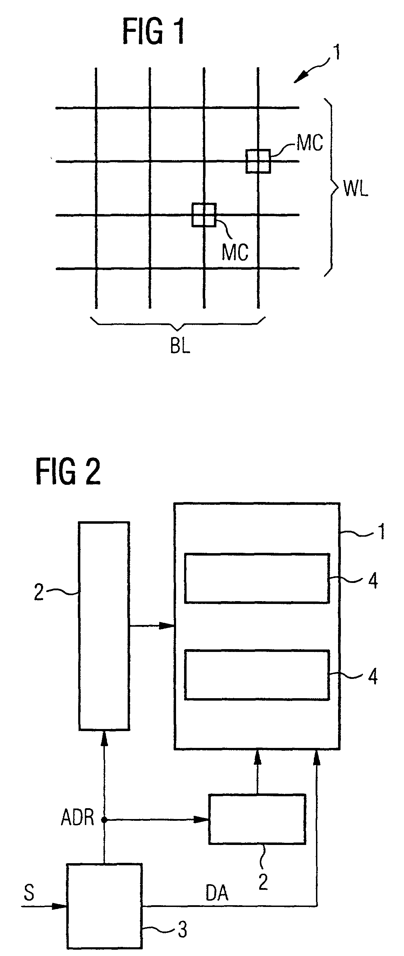

Figur 1 ist ein matrixförmig organisiertes Speicherzellenfeld 1 beispielsweise eines DRAM zu entnehmen, das Zeilenleitungen beziehungsweise Wortleitungen WL und Spaltenleitungen beziehungsweise Bitleitungen BL aufweist, in deren Kreuzungspunkten Speicherzellen MC angeordnet sind. Die Speicherzellen MC des gezeigten Speichers beinhalten jeweils einen Auswahltransistor und einen Speicherkondensator. Dabei sind Steuereingänge der Auswahltransistoren mit einer der Wortleitungen WL verbunden, während ein Hauptstrompfad der Auswahltransistoren zwischen dem Speicherkondensator der jeweiligen Speicherzelle MC und einer der Bitleitungen BL angeordnet ist.

Figur 2 zeigt eine Ausführungsform eines erfindungsgemäßen Halbleiterspeichers. Dieser umfaßt neben dem Speicherzellenfeld 1 einen Decoder 2 zur Auswahl einer der Spaltenleitungen BL und einer der Zeilenleitungen WL sowie eine Steuerungsschaltung 3, die mit dem Speicherzellenfeld 1 und dem Decoder 2 verbunden ist. Zur Auswahl einer der Spaltenleitungen BL beziehungsweise Zeilenleitungen WL durch den Decoder 2 werden von der Steuerungsschaltung 3 die Adressen ADR übergeben. Zum Rücksetzen des Speicherzellenfeldes 1 wird ein vorgegebenes Datensignal DA an das Speicherzellenfeld 1 übertragen. Zum Rücksetzen des Halbleiterspeichers sind die Speicherzellen MC zu Einheiten 4 zusammengefaßt.

Die Einheiten 4 umfassen beispielsweise alle Speicherzellen MC entlang einer der Spaltenleitungen BL oder Zeilenleitungen WL. In einer weiteren Ausführung umfassen die Einheiten 4 nur Speicherzellen MC, die entlang von Spaltenleitungen BL beziehungsweise Zeilenleitungen WL angeordnet sind, die nicht aufeinanderfolgen. So sind die Speicherzellen MC jeweils einer Einheit 4 über das Speicherzellenfeld 1 verteilt. Dadurch wird durch das Löschen einer Einheit 4 von Speicherzellen MC bereits ein weiter Bereich des Speicherzellenfeldes 1 unbrauchbar gemacht.

Das vorgegebene Datensignal DA, mit dem die Speicherzellen MC rückgesetzt werden, weist beispielsweise einen Zustand auf, der dem Zustand "log. 0" entspricht. Weist eine Speicherzelle MC vor dem Rücksetzen einen Zustand auf, der dem Zustand "log. 1" entspricht, so wird durch das Rücksetzen mit dem Datensignal DA der Speicherinhalt dieser Speicherzelle gelöscht.

Im folgenden wird die Funktionsweise des in Figur 2 dargestellten Halbleiterspeichers näher erläutert.

Zum Rücksetzen des Halbleiterspeichers werden die Speicherzellen MC mit dem vorgegebenen Datensignal DA rückgesetzt. Dazu wird die Steuerungsschaltung 3 beispielsweise durch das Steuerungssignal S aktiviert. Zur Auswahl der entsprechenden Einheiten 4 werden Adressen ADR an den Decoder 2 übertragen. Zur Auswahl der Speicherzellen MC der Einheiten 4 ist der Decoder 2 in geeigneter Weise ausgeführt. Mit der entsprechenden Auswahl durch den Decoder 2 werden die Speicherzellen MC innerhalb der Einheiten 4 mit dem Datensignal DA parallel rückgesetzt. Zum vollständigen Rücksetzen des Halbleiterspeichers werden die Einheiten 4 sequentiell abgearbeitet.

Beispielsweise werden alle Zeilenleitungen WL durch den Decoder 2 selektiert sowie eine oder mehrere Spaltenleitungen BL ausgewählt. Durch die Steuerungsschaltung 3 werden die derart ausgewählten Speicherzellen MC mit dem vorgegebenen Datensignal DA rückgesetzt. Dieser Vorgang wird auch als paralleles Spaltenlöschen bezeichnet.

In einer weiteren Ausführung werden eine oder mehrere Zeilenleitungen WL selektiert und die Speicherzellen MC durch Auswahl aller Spaltenleitungen BL mit dem Datensignal DA rückgesetzt. Dieser Vorgang wird auch als paralleles Zeilenlöschen bezeichnet.

Umfaßt dabei eine der Einheiten 4 nur nicht aufeinanderfolgende Spaltenleitungen BL beziehungsweise Zeilenleitungen WL, so liegen die Einheiten 4 in "verzahnter" Weise vor. Es werden also nur Speicherzellen MC parallel rückgesetzt, die in nicht aufeinanderfolgenden Spaltenleitungen BL beziehungsweise Zeilenleitungen WL angeordnet sind. Dadurch kann bereits durch einen einzigen Löschschritt ein weiter Bereich des Speicherzellenfeldes 1 unbrauchbar gemacht werden, so daß die vorher darin gespeicherten Daten möglichst nicht mehr rekonstruierbar sind.

## Patentansprüche

1. Integrierter Halbleiterspeicher
- mit Speicherzellen (MC) in einem Speicherzellenfeld (1),
- mit einem Decoder (2) zur Auswahl einer der Speicherzellen (MC),
- mit einer Steuerungsschaltung (3), die mit dem Speicherzellenfeld (1) und dem Decoder (2) verbunden ist,
- bei dem die Speicherzellen (MC) zu einzelnen Einheiten (4) zusammengefaßt sind,
- bei dem die Steuerungsschaltung (3) und der Decoder (2) derart ausgeführt sind, daß ein paralleles Rücksetzen der Speicherzellen (MC) innerhalb der Einheiten (4) mit einem vorgegebenen Datensignal (DA) und ein sequentielles Rücksetzen der einzelnen Einheiten (4) mit dem vorgegebenen Datensignal (DA) erfolgt.

2. Integrierter Halbleiterspeicher nach Anspruch 1,
**dadurch gekennzeichnet**, daß
- das Speicherzellenfeld (1) im wesentlichen matrixförmig aufgebaut ist, in dem die Speicherzellen (MC) entlang von Spaltenleitungen (BL) und Zeilenleitungen (WL) angeordnet sind, und
- der Decoder (2) zur Auswahl einer der Spaltenleitungen (BL) und einer der Zeilenleitungen (WL) ausgebildet ist.

3. Integrierter Halbleiterspeicher nach Anspruch 2,
**dadurch gekennzeichnet**, daß
eine der Einheiten (4) alle Speicherzellen (MC) entlang einer der Spaltenleitungen (BL) umfaßt.

4. Integrierter Halbleiterspeicher nach einem der Ansprüche 2 oder 3,
**dadurch gekennzeichnet**, daß
eine der Einheiten (4) nur Speicherzellen (MC) umfaßt, die entlang von Spaltenleitungen (BL) angeordnet sind, die nicht aufeinanderfolgen.

5. Integrierter Halbleiterspeicher nach Anspruch 2,
**dadurch gekennzeichnet**, daß
eine der Einheiten (4) alle Speicherzellen (MC) entlang einer der Zeilenleitungen (WL) umfaßt.

6. Integrierter Halbleiterspeicher nach einem der Ansprüche 2 oder 5,
**dadurch gekennzeichnet**, daß
eine der Einheiten (4) nur Speicherzellen (MC) umfaßt, die entlang von Zeilenleitungen (WL) angeordnet sind, die nicht aufeinanderfolgen.

7. Integrierter Halbleiterspeicher nach einem der vorhergehenden Ansprüche,
**dadurch gekennzeichnet**, daß
eine der Einheiten (4) eine Anzahl Speicherzellen (MC) umfaßt, so daß die Speicherzellen (MC) der Einheit (4) im wesentlichen über das gesamte Speicherzellenfeld (1) verteilt sind.

8. Integrierter Halbleiterspeicher nach einem der vorhergehenden Ansprüche,
**dadurch gekennzeichnet**, daß
der integrierte Halbleiterspeicher auf einer Chipkarte angeordnet ist.

9. Verfahren zum Rücksetzen von Speicherzellen (MC) eines integrierten Halbleiterspeichers mit einem vorgegebenen Datensignal (DA), bei dem
- die Speicherzellen (MC) zu Einheiten (4) zusammengefaßt werden,
- die Speicherzellen (MC) innerhalb der Einheiten (4) parallel mit dem vorgegebenen Datensignal (DA) rückgesetzt werden,
- die einzelnen Einheiten (4) sequentiell mit dem vorgegebenen Datensignal (DA) rückgesetzt werden.

10. Verfahren nach Anspruch 9,
**dadurch gekennzeichnet**, daß
- die Speicherzellen (MC) in einem im wesentlichen matrixförmigen Speicherzellenfeld (1) entlang von Spaltenleitungen (BL) und Zeilenleitungen (WL) angeordnet sind,
- alle Zeilenleitungen (WL) selektiert werden und die Speicherzellen (MC) durch Auswahl einer oder mehrerer Spaltenleitungen (BL) mit dem vorgegebenen Datensignal (DA) rückgesetzt werden.

11. Verfahren nach Anspruch 10,
**dadurch gekennzeichnet**, daß
bei der Auswahl der Spaltenleitungen (BL) nur nicht aufeinanderfolgende Spaltenleitungen (BL) ausgewählt werden.

12. Verfahren nach Anspruch 9,
**dadurch gekennzeichnet**, daß
- die Speicherzellen (MC) in einem im wesentlichen matrixförmigen Speicherzellenfeld (1) entlang von Spaltenleitungen (BL) und Zeilenleitungen (WL) angeordnet sind,
- eine oder mehrere Zeilenleitungen (WL) selektiert werden und die Speicherzellen (MC) durch Auswahl aller Spaltenleitungen (BL) mit dem vorgegebenen Datensignal (DA) rückgesetzt werden.

13. Verfahren nach Anspruch 12,
**dadurch gekennzeichnet**, daß
bei der Auswahl der Zeilenleitungen (WL) nur nicht aufeinanderfolgende Zeilenleitungen (WL) ausgewählt werden.
